(19) Europäisches Patentamt
European Patent Office
Office européen des brevets

(11) **EP 0 990 894 B1**

(12) **EUROPÄISCHE PATENTSCHRIFT**

(45) Veröffentlichungstag und Bekanntmachung des Hinweises auf die Patenterteilung:
**22.11.2006 Patentblatt 2006/47**

(51) Int Cl.:
*G01N 27/06* (2006.01)    *G01N 27/07* (2006.01)

(21) Anmeldenummer: **99118100.9**

(22) Anmeldetag: **27.09.1999**

(54) **Verfahren zum Bestimmen der Elektrischen Leitfähigkeit von Flüssigkeiten**

Method for determining the electrical conductivity of liquids

Procédé pour déterminer la conductibilité électrique de liquides

(84) Benannte Vertragsstaaten:
**AT DE FR GB IT NL**

(30) Priorität: **29.09.1998 DE 19844489**

(43) Veröffentlichungstag der Anmeldung:
**05.04.2000 Patentblatt 2000/14**

(73) Patentinhaber: **Endress + Hauser Conducta Gesellschaft für Mess- und Regeltechnik mbH + Co.KG. D-70839 Gerlingen (DE)**

(72) Erfinder: **Riegel, Harald, Dr. Ing. 70499 Stuttgart (DE)**

(74) Vertreter: **Hahn, Christian et al Endress + Hauser (Deutschland)AG +Co. KG PatServe Colmarer Strasse 6 79576 Weil am Rhein (DE)**

(56) Entgegenhaltungen:
**EP-A- 0 580 326         EP-A- 0 911 639**
**DE-A- 4 233 110         GB-A- 1 121 128**
**US-A- 4 227 151         US-A- 5 089 780**
**US-A- 5 489 849**

EP 0 990 894 B1

**Beschreibung**

Die Erfindung betrifft ein Verfahren zum Bestimmen der elektrischen Leitfähigkeit von Flüssigkeiten mittels konduktiv betreibbaren Leitfähigkeitsmesszellen in der Analysen- und Prozessmesstechnik, wobei aus einem gemessenen Widerstands- oder Impedanzwert und der geometrischen Messzellenkonstanten die Leitfähigkeit der Flüssigkeit bestimmt wird.

Unter einer konduktiv betreibbaren Leitfähigkeitsmesszelle ist eine solche zu verstehen, bei der flächenhafte Elektroden in unmittelbarem Kontakt mit der zu messenden Flüssigkeit sind. Zur Bestimmung der elektrolytischen Leitfähigkeit der Flüssigkeit wird der Widerstand oder Leitwert der Elektrodenmessstrecke in der Flüssigkeit beispielsweise unter Verwendung einer Wechselstrommessbrücke bestimmt. Bei bekannter Zellkonstante k lässt sich dann die elektrolytische Leitfähigkeit σ bestimmen.

Im Unterschied zur konduktiven Leitfähigkeitsmessung existiert auch das Prinzip der induktiven Leitfähigkeitsmessung unter Verwendung einer elektrodenlosen Leitfähigkeitsmesszelle, bei der die zu messende Flüssigkeit als induktiv wirkendes Kopplungsmedium zwischen einer Erregerspule und einer Messspule verwendet wird. Die vorliegende Erfindung bezieht sich jedoch auf das konduktive Leitfähigkeitsmessverfahren.

Die physikalischen Zusammenhänge der Stromleitung in Elektrolyt-Flüssigkeiten sind wie folgt:

Je nach Dissoziationsverhalten sind die betrachteten elektrolytischen Bestandteile in der Flüssigkeit in mehr oder weniger großem Umfang in ihre Ionen zerfallen (dissoziiert). Diese Ionen sind für den elektrischen Stromtransport in der Flüssigkeit verantwortlich. Der tatsächliche Grad der Dissoziation eines Elektrolyts hängt desweiteren von der Konzentration dieses Stoffs in der Flüssigkeit und von der Temperatur ab. Auch das Trägermedium als solches, also beispielsweise bei wässrigen Lösungen, das Wasser, trägt durch Dissoziation zur Leitfähigkeit bei. Über weite Bereiche nimmt die elektrolytische Leitfähigkeit mit steigender Konzentration der Elektrolyte zu.

Die Messung der elektrolytischen Leitfähigkeit stellt neben der Bestimmung des pH-Werts ein einfach und mit hoher Genauigkeit durchführbares Mittel der Analysen- und Prozesskontrolle, insbesondere bei automatisierten Prozessen, dar.

Die elektrolytische Leitfähigkeit σ einer Flüssigkeit ist definiert als Produkt einer geometrischen Konstanten der Elektrodenmesszelle, der sogenannten Zellkonstanten k, und dem reziproken elektrischen ohmschen Widerstand der Flüssigkeit zwischen den Elektroden.

$$\sigma = k \cdot \frac{1}{R}$$

Für eine Messstrecke der Länge L und der Querschnittsfläche A mit entsprechender Oberfläche A der Elektroden ergibt sich der als Messgrösse erfassbare elektrische Widerstand R als Produkt des spezifischen Widerstands $\rho$ und des Quotienten Länge / Fläche, also L/A

$$R = \rho \cdot \frac{L}{A}$$

Aus dem gemessenen elektischen Widerstand lässt sich daher der spezifische Widerstand $\rho$ berechnen, als dessen reziproker Wert die Leitfähigkeit σ definiert ist. Somit gilt

$$\rho = R \cdot \frac{A}{L}$$

$$\sigma = \frac{1}{\rho} = \frac{1}{R} \cdot \frac{L}{A}$$

Die eingangs erwähnte geometrische Konstante (Zellkonstante) dieser speziellen Elektroden-Messstrecke ist daher L/A.

Der Messbereich einer Leitfähigkeitsmesszelle ist auf der Seite zu einer hohen Leitfähigkeit hin durch die physikalischen Vorgänge des Phasenübergangs von der festen Metallelektrode in die Flüssigkeit beschränkt. Im Idealfall verhält sich diese Impedanz des Phasenübergangs rein kapazitiv, und zwar aufgrund der sich ausbildenden elektrochemischen Doppelschicht. Tatsächlich hat aber die Impedanz dieses Phasenübergangs auch einen realen, d.h. ohmschen Anteil. Das Messergebnis wird also verfälscht, wenn dieser Realteil der Impedanz des Phasenübergangs gegenüber dem interessierenden Widerstand der Flüssigkeit nicht zu vernachlässigen ist. Hieraus ergibt sich die Beschränkung des Messbereichs einer Leitfähigkeitsmesszelle nach oben, da seither bei der Auswertung nur der ohmsche Widerstand der Flüssigkeit nicht aber derjenige des Phasenübergangs von der festen Metallelektrode in die Flüssigkeit Z berücksichtigt wurde.

Hiervon ausgehend liegt der vorliegenden Erfindung die Aufgabe zugrunde, die Fehler bei der Bestimmung der elektrischen Leitfähigkeit nach dem Verfahren der eingangs beschriebenen Art zu reduzieren.

Diese Aufgabe wird durch ein Verfahren der eingangs genannten Art gelöst, das erfindungsgemäß gekennzeichnet ist durch folgende Verfahrensschritte:

Unter Verwendung eines Messumformers wird bei wenigstens zwei Frequenzwerten einer Wechselspannung die Impedanz der in die Flüssigkeit eintauchenden Messzelle ermittelt;
aus den ermittelten Impedanzwerten werden unter Zugrundelegung eines Ersatzschaltbildes frequenzunabhängige Parameter n, Q und der gesuchte Widerstand $R_{fl}$ bestimmt,

wobei das Ersatzschaltbild aus einer Parallelschaltung eines die Messzellenkapazität darstellenden Kondensators $C_{Zelle}$ und eines den gesuchten Widerstand der Flüssigkeit innerhalb der Leitfähigkeitsmesszelle darstellenden ohmschen widerstands $R_{fl}$ sowie eines mit dem ohmschen widerstand $R_{fl}$ in Reihe geschalteten elektrischen Bauelements $z_{M/F1}$ mit einer frequenzunabhängigen Phase besteht, und das Bauelement ($Z_{M/F1}$) durch folgende Impedanz

$$Z_{M/Fl} = \frac{1}{(i\,\omega/\omega_0)^n \cdot Q}$$

beschrieben wird.

Nachdem der gesuchte Widerstand $R_{fl}$ auf die vorstehende Weise bestimmt wurde, kann aus dem eingangs beschriebenen Zusammenhang zwischen dem Widerstand $R_{fl}$ und der Leitfähigkeit $\sigma$ unter Verwendung der Zellkonstanten k die Leitfähigkeit $\sigma$ berechnet werden ($\sigma = 1/R_{fl}\,k$).

Dadurch, dass nach der Erfindung die physikalischen Vorgänge am Phasenübergang von der festen Metallelektrode zur Flüssigkeit berücksichtigt werden, indem nach der Erfindung aus mehreren Messwerten unter Zugrundelegung des vorstehend geschilderten Ersatzschaltbilds derjenige ohmsche Widerstand $R_{fl}$, der allein auf die interessierende Messflüssigkeit zurückzuführen ist, rechnerisch ermittelt wird, lässt sich der Fehler bei der Bestimmung der elektrolytischen Leitfähigkeit im Bereich des oberen Endes des für eine spezifische Messzellenanordnung gegebenen Messbereichs reduzieren. Mit anderen Worten ausgedrückt lässt sich der Leitfähigkeitsmessbereich einer bestimmten Messzellenanordnung nach oben ausweiten. Es kann hierbei eine Messbereichserweiterung um einen Faktor 10 erreicht werden.

Nach einer bevorzugten Ausführungsform der Erfindung umfasst das Bauelement, welches die physikalischen Vorgänge im Bereich des Phasenübergangs von der festen Metallelektrode zu Flüssigkeit simulieren soll, zwei frequenzunabhängige Parameter auf, und es werden, um diese Parameter sowie den gesuchten Widerstand berechnen zu können, bei zwei Frequenzwerten jeweils eine Messung des Realteils und des Imaginärteils der Impedanz der in die Flüssigkeit eintauchenden Messzelle ermittelt.

Stehen zur Durchführung des Verfahrens jedoch nur Messumformer zur Verfügung, bei denen der Realteil oder der Betrag der Impedanz der in die Flüssigkeit eintauchenden Messzellenanordnung ermittelt werden kann, so werden Impedanzmessungen bei wenigstens drei Frequenzwerten benötigt.

Eine bevorzugte Beschreibung des Bauelementes Z ist in den abhängigen Ansprüchen beschrieben.

Es sei an dieser Stelle noch darauf hingewiesen, dass sich die Erfindung als besonders vorteilhaft erweist, für die Messung der elektrischen Leitfähigkeit von Flüssigkeiten im Messbereich von weniger 200 $\mu$S/cm, insbesondere von weniger 100 $\mu$S/cm auswirkt, da durch die erfindungsgemäße Messbereichserweiterung Kalibrierlösungen verwendet werden können, deren Leitfähigkeitswerte zuvor nicht innerhalb des Messbereichs der jeweils betrachteten Leitfähigkeitsmesszelle liegen. Insoweit erweist es sich als besonders vorteilhaft, dass der Leitfähigkeitsmessbereich beispielsweise einer Reinstwassermesszelle mit einer Zellkonstanten von 0,01 cm$^{-1}$ von ca. 20 $\mu$S/cm auf 200 $\mu$S/cm erhöht werden kann. Dies bietet aber die Möglichkeit, diese Leitfähigkeitsmesszelle unter Verwendung einer Kalibrierlösung im Leitfähigkeitsbereich von 100 bis 200 $\mu$S/cm zu kalibieren, beispielsweise unter Verwendung von Kalibrierlösungen nach DIN IEC 746-3, ASTM 1125-91.

Unter dem Kalibrieren einer Leitfähigkeitsmesszelle wird die Bestimmung der geometrischen Zellkonstanten k verstanden, die eingangs bei einer zylindrischen Elektrodenmessstrecke zu L/A berechnet wurde.

Da exakte Kalibrierlösungen im Leitfähigkeitsbereich unterhalb von 100 $\mu$S/cm nicht mehr reproduzierbar und unabhängig von weiteren Größen zur Verfügung stehen, musste seither zum Bestimmen der geometrischen Zellkonstante k einer Leitfähigkeitsmesszelle eine weitere Leitfähigkeitsmesszelle verwendet werden, deren den Genauigkeitsanforderungen genügender Messbereich sich einerseits von oben, also von höheren Leitfähigkeiten herkommend, mit dem in Rede stehenden Messbereich des zu kalibrierenden Sensors überlappt und andererseits soweit nach oben erstreckt, dass hinreichend reproduzierbare Kalibrierlösungen verwendbar sind. Solchenfalls wurde also zunächst eine erste Leitfähigkeitsmesszelle im höheren Leitfähigkeitsmessbereich kalibriert, und unter Verwendung dieser Zelle wurde dann die in Rede stehende Leitfähigkeitsmesszelle im sehr niedrig liegenden Leitfähigkeitsbereich kalibriert. Durch die erfindungsgemäß herbeigeführte Messbereichserweiterung nach oben ist dies nicht mehr erforderlich, da im Bereich beispielsweise zwischen 100 und 200 $\mu$S/cm reproduzierbare Kalibrierlösungen, mit einer Leitfähigkeit von beispielsweise 149,6 $\mu$S/cm zur Verfügung stehen.

Die Kalibrierung, d.h. die Bestimung der geometrischen Zellkonstanten von Leitfähigkeitsmesszellen ist im Allgemeinen erforderlich, da auf Grund von montagebedingten Ungenauigkeiten die Zellkonstante - wenn sie lediglich rechnerisch ermittelt Würde - nicht der geforderten Genauigkeit von z.B. 0,5 % entsprechen würde. Da die Zellkonstante einer Leitfähigkeitsmesszelle mit zylindrischen Elektroden bestimmt ist durch

$$ k \approx \frac{1}{l} \cdot \ln\frac{R}{r} $$

l = Länge der Anordnung
R = innerer Radius der äußeren Elektrode
r = äußerer Radius der inneren Elektrode

Bei der Herstellung der Messzelle erweist sich die konzentrische Anordnung der inneren Elektrode als problematisch. Der hierauf zurückzuführende Fehler ist daher gegeben durch

$$ \frac{\Delta k}{k} \approx \frac{\Delta r}{r} \cdot \frac{1}{\ln\frac{R}{r}} $$

diese konstruktionsbedingten Ungenauigkeiten zu reduzieren wird erreicht durch ein Verfahren zum Herstellen einer Leitfähigkeitsmesszelle mit zylindrischen, konzentrischen Elektroden, die an einem vorzugsweise aus Kunststoff gegossenen Grundkörper gehalten sind, der die elektrische Zuführung beinhaltet, wobei die Innenelektrode auf einem Haltezapfen dauerhaft montiert wird und anschließend die Außenelektrode über die Innenelektrode gestülpt und dabei in kraft- oder formschlüssig wirkende Halteverbindung mit einem gegenüber der Innenelektrode durchmessergrößeren Abschnitt des Grundkörpers gebracht wird, wobei das Verfahren dadurch gekennzeichnet ist, dass vor dem Montieren der Innenelektrode ein Montagemittel auf den vorstehend erwähnten Abschnitt des Grundkörpers aufgeschoben und als Führungsmittel für den Außenumfang der Innenelektrode verwendet wird, wenn diese auf den Haltezapfen aufgeschoben wird.

Auf diese Weise wird erreicht, dass die Innenelektrode exakt zur geometrischen Längsmittelachse konzentrisch montiert wird. Dies ist nunmehr unter Verwendung des Montagemittels möglich, so dass auf eine Kalibrierung der auf diese Weise hergestellten Leitfähigkeitsmesszellen verzichtet werden kann. Die Zellkonstante wird durch eine vereinfachte Überprüfung der Geometrie errechnet.

Das erwähnte Montagemittel ist vorzugsweise hülsenförmig, was jedoch nicht notwendigerweise der Fall sein muss, da das Montagemittel nach dem Aufbringen der Innenelektrode wieder abgezogen wird. Das Montagemittel weist einen innen zylindrischen Führungsabschnitt auf, dessen Innendurchmesser dem Außendurchmesser der Innenelektrode entspricht, so dass diese beim Aufschieben auf den Haltezapfen eine Zentrierung bzw. Führung erfährt.

Das Montagemittel selbst wird vorteilhafterweise mit einem gegenüber dem Führungsabschnitt durchmessergrößeren Abschnitt an dem vorstehend erwähnten Abschnitt des Grundkörpers temporär, also zum Montieren der Innenelektrode, festgelegt. Dieser Abschnitt des Grundkörpers bildet dann nach Entfernen des Montagemittels ein Führungsmittel für die Außenelektrode. Vorteilhafterweise beträgt die axiale Erstreckung dieses Abschnitts nahezu 50 % der axialen Länge der Außenelektrode, so dass hierdurch eine zufriedenstellende Zentrierung, d.h. konzentrische Anordnung der Außenelektrode erreicht werden kann.

Es wurde eingangs bereits auf das Problem hingewiesen, dass Kalibrierlösungen im Leitfähigkeitsmessbereich unterhalb von 100 µS/cm nicht oder nicht unabhängig von anderen Größen zur Verfügung stehen. Dies erweist sich insbesondere bei Leitfähigkeitsmesszellen zur Bestimmung der Leitfähigkeit bei der Herstellung von Reinstwasser durch Einsatz einschlägig bekannter Filtertechnologie als problematisch. Es wird daher vorgeschlagen, als Kalibrierflüssigkeit bereits definiertes Reinstwasser zu verwenden. Die Leitfähigkeit von Reinstwasser ist bei 25°C mit einer Genauigkeit von 0,3 % bekannt. Es ist Reinstwasser mit einem Analysezertifikat des Herstellers im Handel erhältlich, welches eine Leitfähigkeit von 55 nS/cm bei 25°C aufweist. Verwendet man Reinstwasser als Kalibrierlösung, dann lässt sich eine wesentlich genauere Zellkonstantenbestimmung bei den Leitfähigkeitsmesszellen, die in Prozessen zur Herstellung von Reinstwasser eingesetzt werden, erreichen. Die Verwendung einer bei höheren Leitfähigkeiten kalibrierten Messzelle zum Kalibrieren derjenigen Messzelle für den sehr niedrigen Leitfähigkeitsbereich kann daher entfallen.

Weitere Einzelheiten, Merkmale und Vorteile der Erfindung ergeben sich aus der nachfolgenden Beschreibung des erfindungsgemäßen Verfahrens und seiner Hintergründe und Vorteile anhand der beigefügten Figuren. In der Zeichnung zeigt:

Figur 1    eine Darstellung eines zur Durchführung des erfindungsgemäßen Verfahrens verwandten Ersatzschaltbilds;

Figur 2    ein Impedanzspektrum umfassend die Impedanz sowie die Phase einer in eine zu messende Flüssigkeit eintauchenden Elektrodenmessstrecke in Abhängigkeit der Frequenz einer Erregerspannung, gemessen und berechnet für drei Modelle der Impedanz $Z_{M/fl}$;

Figur 3    eine teilweise geschnittene Darstellung einer Leitfähigkeitsmesszelle mit Montagehülse für die Innenelektrode.

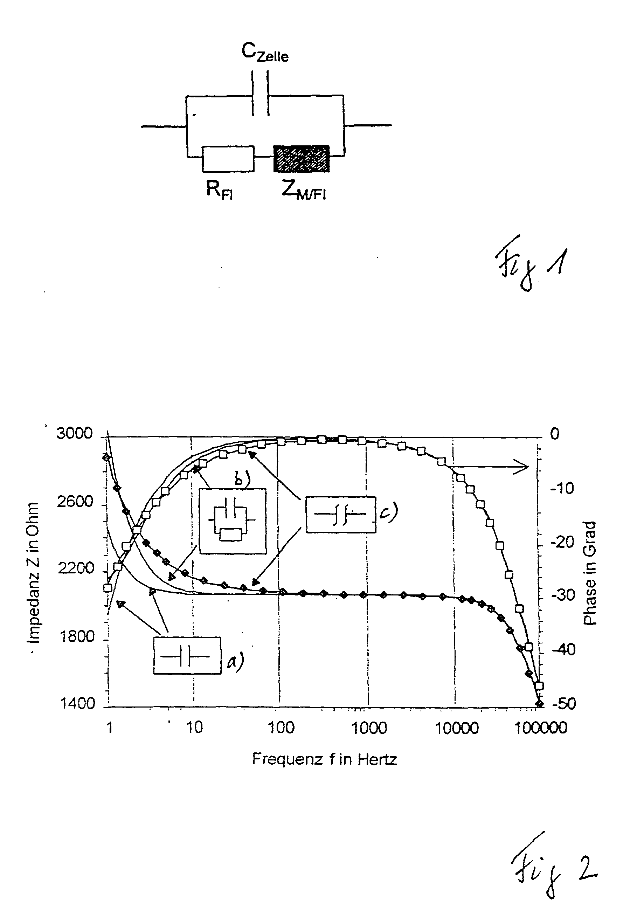

Figur 1 zeigt ein Ersatzschaltbild einer in eine elektrolytische Flüssigkeit eintauchenden Elektrodenmessanordnung einer Leitfähigkeitsmesszelle. Das Ersatzschaltbild besteht aus einer zwei Arme aufweisenden Parallelschaltung, wobei der eine Arm von einem Kondensator $C_{Zelle}$ gebildet ist, dessen Kapazität die Kapazität der Elektrodenanordnung darstellt und der andere Arm aus einer Reihenschaltung eines Widerstands $R_{fl}$ und eines Bauelements $Z_{M/F1}$ besteht. Bei dem Widerstand $R_{fl}$ handelt es sich um den ohmschen Widerstand der zu treffenden Flüssigkeit. Das Bauelement $Z_{M/F1}$ repräsentiere oder simuliere die Vorgänge am Phasenübergang zwischen der festen Metallelektrode und der Flüssigkeit.

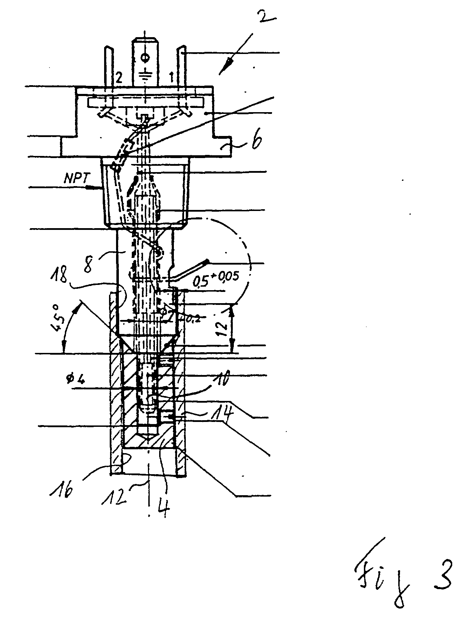

In Figur 2 ist grafisch aufgetragen in ausgefüllten schwarzen Messpunkten die bei einer Vielzahl von Frequenzen gemessene Impedanz Z der in die Messflüssigkeit eintauchenden Messelektrodenanordnung. Die nichtausgefüllten Messpunkte stellen die dabei gemessene Phasenlage des Stroms als Antwort auf die Erregerspannung dar.

Es wurden dann in Form der durchgezogenen Linien unter Zugrundelegung des Ersatzschaltbilds nach Figur 1 verschiedene Ansätze des Bauelements $Z_{Mfl}$ gemacht. Die beiden Kurven gemä Ziffer a) stellen die berechnete Impedanz Z sowie die Phase bei Zugrundelegung des Bauelements $Z_{Mfl}$ in Form eines Kondensators (rein kapazitiv) dar.

Ein besseres Ergebnis liefert der Ansatz b), wonach das Bauelement Z in Form einer Parallelschaltung eines Widerstands und eines Kondensators dargestellt wurde. Die allerbesten Ergebnisse wurden aber mit einem Bauelement c) erreicht. Die Impedanz dieses Bauelements ist wie folgt:

$$Z_{M/fl} = \frac{1}{(i\omega/\omega_o)^n \cdot Q.}$$

Das Bauelement weist zwei frequenzunabhängige Parameter n und Q auf.

Unter Zugrundelegung des vorstehend erwähnten Bauelements hat man also zwei frequenzunabhängige Parameter n und Q, wobei der zu ermittelnde Widerstand $R_{fl}$ der Flüssigkeit einen dritten Parameter, also eine dritte gesuchte Unbekannte darstellt. Wenn mit einem Messumformer gearbeitet wird, der geeignet ist, sowohl den Realteil (Z') als auch dem Imaginärteil (Z") der zu bestimmenden Impedanz zu messen, so reichen zwei Messungen bei verschiedenen Frequenzen aus, um anhand der vier Größen die Unbekannten zu berechnen.

Bei einer Zellenkapazität von $C_{Zelle}$ = 805 pF und einem Wert $\omega_o$ von $2\pi \cdot$ 1 Hz wurden die Werte n = 0,766 und Q = 170 $\mu$S sowie ein Widerstand der Messflüssigkeit von R = 2063 Ohm berechnet.
Der gesuchte Flüssigkeitswiderstand R berechnet sich wie folgt:

$$R_{Fl} = \frac{Z'(\omega_2)Z''(\omega_1) - Z'(\omega_1)Z''(\omega_2)}{Z''(\omega_1) - Z''(\omega_2)}$$

Steht nur ein Messumformer zur Verfügung, bei dem der Realteil oder der Betrag der Impedanz gemessen werden kann, dann sind zur Bestimmung der drei Unbekannten Messungen bei drei verschiedenen Frequenzen erforderlich. Eine Auswertung der linear unabhängigen Gleichung führt auf ein transzedentes Gleichungssystem, das im Allgemeinen nicht exakt gelöst werden kann, sondern einer nummerischen Behandlung bedarf. Es steht jedoch eine exakte Lösung für das nachfolgende Frequenzverhältnis f3 = 10f2 = 100f1 zur Verfügung, wonach sich der Flüssigkeitswiderstand berechnet gemäß

$$R_{fl} = \frac{Z'(\omega_1)Z'(\omega_2) - Z'(\omega_3)^2}{Z'(\omega_1) + Z'(\omega_2) + 2Z'(\omega_3)}$$

Je nach zu Verfügung stehendem Messumformer kann auf die eine oder andere Weise der ohmsche Widerstand $R_{fl}$, also derjenige Realteil der Gesamtimpedanz der in die Messflüssigkeit eintauchenden Messelektrodenanordnung, der auf die zu bestimmende Flüssigkeit zurückgeht, berechnet werden. Aus diesem ohmschen Widerstand lässt sich dann durch Multiplikation seines reziproken Werts mit der geometrischen Zellkonstanten k der Messelektrodenanordnung die Leitfähigkeit $\sigma$ der Flüssigkeit bestimmen.

Die geometrische Zellkonstante k der Leitfähigkeitsmesszelle wird vorzugsweise durch Messung des ohmschen Widerstands der in eine Kalibrierflüssigkeit eintauchenden Messzellenanordnung bestimmt.

Figur 3 zeigt eine teilweise geschnittene Darstellung einer Leitfähigkeitsmesszelle mit zylindrischen Elektroden, wobei nur eine Innenelektrode 4 dargestellt ist. Die Leitfähigkeitsmesszelle 2 umfasst einen aus Epoxyharz gegossenen Grundkörper 6. Der Grundkörper 6 umfasst einen ersten Abschnitt 8 und einen von der Stirnseite des Abschnitts 8 vorstehenden Haltezapfen 10. Auf den Haltezapfen 10 ist die Innenelektrode 4 aufschiebbar. Damit die Innenelektrode 4 exakt konzentrisch zur angedeuteten Längsmittelachse 12 der Anordnung am Haltezapfen 10 montiert wird, wird zuvor eine Montagehülse 14 auf den ersten Abschnitt 8 aufgeschoben. Die Montagehülse 14 umfasst einen Führungsabschnitt 16 mit einem dem Außendurchmesser der Innenelektrode 4 exakt entsprechenden Innendurchmesser. Sie ist mit einem demgegenüber durchmessergrößeren Abschnitt 18 auf den ersten Abschnitt 8 des Grundkörpers 6 aufgeschoben. Nach der Montage der Innenelektrode 4 wird die Montagehülse 14 entfernt und eine nicht dargestellte Außenelektrode wird auf den ersten Abschnitt 8 des Grundkörpers 6 aufgeschoben. Die Außenelektrode erstreckt sich dabei im Wesentlichen über die gesamte axiale Länge des ersten Abschnitts 8 und erfährt dadurch eine exakte Positionierung konzentrisch zur Längsmittelachse 12. Die auf diese Weise hergestellte Leitfähigkeitsmesszelle bedarf keiner experimentellen Kalibrierung, sondern die Zellkonstante k kann mit hinreichender Genauigkeit durch vereinfachte Überprüfung der Zellengeometrie bestimmt werden.

**Patentansprüche**

1. Verfahren zum Bestimmen der elektrischen Leitfähigkeit von Flüssigkeiten mittels konduktiv betreibbaren Leitfähigkeitsmesszellen in der Analysen- und Prozessmesstechnik, wobei aus einem gemessen widerstandswert ($R_{fl}$) und der geometrischen Messzellenkonstanten (k) die Leitfähigkeit der Flüssigkeit bestimmt wird, **gekennzeichnet durch** folgende Verfahrensschritte:

   unter Verwendung eines Messumformers wird bei wenigstens zwei Frequenzwerten einer Wechselspannung die Impedanz der in die Flüssigkeit eintauchenden Messzelle ermittelt,
   aus den ermittelten Impedanzwerten werden unter Zugrundelegung eines Ersatzschaltbildes frequenzunabhängige Parameter (n, Q) und der gesuchte widerstand ($R_{fl}$) bestimmt,

   wobei das Ersatzschaltbild aus einer Parallelschaltung eines die Messzellenkapazität darstellenden Kondensators ($C_{Zelle}$) und eines den gesuchten widerstand der Flüssigkeit innerhalb der Leitfähigkeitsmesszelle darstellenden ohmschen Widerstands ($R_{fl}$) sowie eines mit dem ohmschen Widerstand ($R_{fl}$) in Reihe geschalteten elektrischen Bauelements ($Z_{M/F1}$) mit einer frequenzunabhängigen Phase besteht, und das Bauelement ($Z_{M/F1}$) **durch** folgende Impedanz

$$Z_{M/F1} = \frac{1}{(i\,\omega/\omega_0)^n \cdot Q}$$

   beschrieben wird.

2. verfahren nach Anspruch 1, **dadurch gekennzeichnet, dass** bei zwei Frequenzwerten ($\omega_1$, jeweils eine Messung des Realteils (Z') und des Imaginärteils (Z'') der Impedanz der in die Flüssigkeit eintauchenden Messzelle ermittelt wird und hieraus die frequenzunabhängigen Parameter (n, Q) und der gesuchte Widerstand ($R_{fl}$) berechnet wird.

3. Verfahren nach Anspruch 1, **dadurch gekennzeichnet, dass** bei wenigstens drei Frequenzwerten ($\omega_1$, $\omega_2$, $\omega_3$) eine Messung nur des Realteils oder des Betrags der Impedanz durchgeführt und hieraus die frequenzunabhängigen Parameter (n, Q) und der gesuchte Widerstand ($R_{fl}$) berechnet werden.

4. Verfahren nach Anspruch 3, **dadurch gekennzeichnet, dass** die Frequenzwerte folgendermaßen gewählt werden

$$\omega_3 = 10\ \omega_2 = 100\ \omega_1.$$

5. Verfahren nach einem der vorstehenden Ansprüche zum Bestimmen der elektrischen Leitfähigkeit von Flüssigkeiten im Messbereich von weniger 200 $\mu$S/cm, **dadurch gekennzeichnet, dass** zu einer Bestimmung der geometrischen Zellkonstanten (k) der Leitfähigkeitsmesszelle eine Kalibrierlösung verwendet wird.

6. Verfahren nach Anspruch 5, **dadurch gekennzeichnet, dass** die Kalibrierlösung eine Leitfähigkeit im Bereich von 100 - 200 $\mu$S/cm aufweist.

**Claims**

1. A method for determining the electrical conductivity of fluids by means of conductively operable conductivity measuring cells in analysis and process measuring technology, the conductivity of the fluid being determined from a measured resistance value ($R_{f1}$) and the geometric measuring cell constant (k), **characterised by** the following method steps:

EP 0 990 894 B1

using a measuring transducer, the impedance of the measuring cell immersed in the fluid is ascertained at at least two frequency values of an AC voltage,

frequency-independent parameters (n, Q) and the sought resistance ($R_{fl}$) are determined from the ascertained impedance values, taking an equivalent circuit diagram as basis,

the equivalent circuit diagram consisting of a parallel connection of a capacitor ($C_{cell}$) representing the measuring cell capacitance and an ohmic resistance (Rn) representing the sought resistance of the fluid inside the conductivity measuring cell, and also an electrical component ($Z_{M/F1}$), connected in series with the ohmic resistance ($R_{f1}$), with a frequency-independent phase, and the component ($Z_{M/F1}$) being described by the following impedance

$$Z_{M/F1} = \frac{1}{(i\frac{\omega}{\omega_n})^n \cdot Q}$$

2. A method according to Claim 1, **characterised in that**, at two frequency values ($\omega_1$, $\omega_2$), a measurement of the real part (Z') and of the imaginary part (Z") of the impedance of the measuring cell immersed in the fluid is determined in each case, and from it [are][1] calculated the frequency-independent parameters (n, Q) and the sought resistance ($R_{fl}$).

   [1] Singular verb in the source text.

3. A method according to Claim 1, **characterised in that**, at at least three frequency values ($\omega_1$, $\omega_2$, $\omega_3$), a measurement only of the real part or of the amount of the impedance is implemented, and from it are calculated the frequency-independent parameters (n, Q) and the sought resistance ($R_{f1}$).

4. A method according to Claim 3, **characterised in that** the frequency values are selected as follows

$$\omega_3 = 10 \quad \omega_2 = 100 \quad \omega_1.$$

5. A method according to one of the preceding claims for determining the electrical conductivity of fluids in the measuring range of less than 200 $\mu$S/cm, **characterised in that** a calibrating solution is used for determining the geometric cell constant (k) of the conductivity measuring cell.

6. A method according to Claim 5, **characterised in that** the calibrating solution has a conductivity in the range of 100 - 200 $\mu$S/cm.


**Revendications**

1. Procédé destiné à la détermination de la conductivité électrique de liquides au moyen de cellules de mesure de conductivité conductives dans la technique d'analyse et de mesure de process, la conductivité du liquide étant déterminée à partir d'une valeur mesurée de résistance ($R_{f1}$) et des constantes géométriques des cellules de mesure, **caractérisé par** les étapes de procédé suivantes :

   l'impédance de la cellule de mesure immergée dans le liquide est déterminée au moyen d'un transmetteur pour au moins deux valeurs de fréquence d'une tension alternative,
   les paramètres indépendants de la fréquence (n, Q) et la résistance recherchée ($R_{f1}$) sont déterminés à partir des valeurs d'impédance mesurées, à l'appui d'un schéma équivalent,
   le schéma équivalent étant constitué d'un couplage en parallèle d'un condensateur ($C_{Cellule}$) et d'une résistance ohmique ($R_{f1}$) représentant la résistance recherchée du liquide au sein de la cellule de mesure de conductivité, ainsi que d'un composant électrique ($Z_{M/F1}$) couplé en série avec la résistance ohmique ($R_{f1}$), dont la phase est indépendante de la fréquence, et le composant ($Z_{M/F1}$) étant décrit par l'impédance suivante :

$$Z_{MIFI} = \frac{1}{(i\omega/\omega_0)^n \cdot Q}$$

2. Procédé selon la revendication 1, **caractérisé en ce qu'**une mesure de la part réelle (Z') et de la part imaginaire (Z") de l'impédance de la cellule de mesure immergée dans le liquide est respectivement déterminée pour deux valeurs de fréquence ($\omega_1$, $\omega_2$) et qu'à partir de cette mesure sont calculés les paramètres indépendants de la fréquence (n, Q) et la résistance recherchée ($R_{f1}$).

3. Procédé selon la revendication 1, **caractérisé en ce qu'**une mesure uniquement de la part réelle ou de la valeur de l'impédance est réalisée pour au moins trois valeurs de fréquence ($\omega_1$, $\omega_2$, $\omega_3$) et qu'à partir de cette mesure sont calculés les paramètres indépendants de la fréquence (n, Q) et la résistance recherchée ($R_{f1}$).

4. Procédé selon la revendication 3, **caractérisé en ce que** les valeurs de fréquence sont choisies comme suit :

$$\omega_3 = 10\,\omega_2 = 100\,\omega_1.$$

5. Procédé selon l'une des revendications précédentes destiné à la détermination de la conductivité électrique de liquides dans la gamme de mesure inférieure à 200 $\mu$s/cm ; **caractérisé en ce qu'**une solution d'étalonnage est utilisée pour une détermination des constantes de cellule géométriques (k) de la cellule de mesure de conductivité.

6. Procédé selon la revendication 5, **caractérisé en ce que** la solution d'étalonnage présente une conductivité dans la gamme de 100 - 200 $\mu$s/cm.

Fig 1

Fig 2

Fig 3